## Europäisches Patentamt

(19) **European Patent Office**

**Office européen des brevets**

(11) Veröffentlichungsnummer: **0 127 139**
**B1**

(12) **EUROPÄISCHE PATENTSCHRIFT**

(45) Veröffentlichungstag der Patentschrift:
06.04.87

(21) Anmeldenummer: **84105940.5**

(22) Anmeldetag: **24.05.84**

(51) Int. Cl.⁴: **G 01 R 19/165**

(54) Schaltungsanordnung zum Überwachen einer Betriebsspannung.

(30) Priorität: **27.05.83 DE 3319306**

(43) Veröffentlichungstag der Anmeldung:
**05.12.84 Patentblatt 84/49**

(45) Bekanntmachung des Hinweises auf die Patenterteilung:
**06.04.87 Patentblatt 87/15**

(84) Benannte Vertragsstaaten:
**CH DE FR GB IT LI SE**

(56) Entgegenhaltungen:
**DE-A-3 130 067**
**US-A-3 911 360**
**US-A-4 260 907**

**IBM TECHNICAL DISCLOSURE BULLETIN, Band 19,
Nr. 5, Oktober 1976, Seiten 1777-1778, New York,
USA; I. SHELTON Jr. et al.: "Voltage-dip sensor"**

(73) Patentinhaber: **Siemens Aktiengesellschaft Berlin
und München, Wittelsbacherplatz 2, D-8000
München 2 (DE)**

(72) Erfinder: **Füchsle, Willy, Ing.grad., Albrecht- Dürer-
Strasse 70, D-8037 Olching (DE)**

EP 0 127 139 B1

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

LIBER, STOCKHOLM 1987

## Beschreibung

Die Erfindung bezieht sich auf eine Schaltungsanordnung zum überwachen einer Betriebsspannung entsprechend dem Oberbegriff des Patentanspruchs 1.

Bei elektronischen Schaltungen ist es häufig erforderlich, die Betriebsspannung zu überwächen. Dies gilt insbesondere für digitale Schaltwerke, in denen nach einer Störung der Betriebsspannung, ebenso wie beim Einschalten oder Ausschalten definierte Zustände eingestellt werden müssen. In derartigen Schaltwerken ist es daher häufig erforderlich, ein eine Störung der Betriebsspannung anzeigendes Steuersignal zu erzeugen, das als Rücksetzsignal für die digitalen Schaltglieder verwendbar ist.

Es wäre denkbar, für eine derartige Schaltungsanordnung einen Kondensator vorzusehen, der über einen Ladewiderstand mit der Betriebsspannung verbunden ist und die Spannung am Kondensator unter Verwendung eines Komparators mit einer festen Bezugsspannung zu vergleichen. Solange die Spannung am Kondensator kleiner als die Bezugsspannung ist, gibt der Komparator das Steuersignal ab. Parallel zu dem Ladewiderstand kann eine Serienschaltung aus einer Diode und einem weiteren Widerstand vorgesehen sein, um beim Abschalten der Betriebsspannung oder bei einem Einbruch der Betriebsspannung den Kondensator möglichst schnell zu entladen, so daß die Spannung am Kondensator wieder unter die Bezugsspannung fällt und wieder das Steuersignal erzeugt wird.

Eine derartige Schaltungsanordnung hat den Nachteil, daß Einbrüche der Betriebsspannung von kurzer Dauer, beispielsweise von einigen Mikrosekunden zu keiner vollständigen Entladung des Kondensators führen und daß außerdem die Dauer des Steuersignals abhängig von der Restladung auf dem Kondensator variiert. Weiterhin hat eine derartige Schaltungsanordnung den Nachteil, daß sie zum Schwingen neigt, wenn die Spannung am Kondensator einen Wert aufweist, der dem Wert der Bezugsspannung entspricht.

Aus der US-A-3,911,360 ist eine Schaltungsanordnung zum Überwachen einer Spannung bekannt, bei der ein ersten Komparator vorgesehen ist, an dessen erstem Eingang eine erste Bezugsspannung anliegt und an dessen zweitem Eingang über ein RC-Glied eine zu überwachende Spannung anliegt. An dem Ausgang des Komparators ist der Setzeingang eines Flipflops angeschlossen, dessen Ausgang mit einer als Anzeigeeinheit dienenden lichtemittierende Diode verbunden ist. Die Schaltungsanordnung erhält einen zweiten Komparator, an dessen erstem Eingang eine zweite Bezugsspannung anliegt und an dessen zweitem Eingang über einen Rücksetzschalter die zu überwachende Spannung anliegt. Ein Ausgang des zweiten Komparators ist mit dem Rücksetzeingang des Flipflops verbunden.

Der Erfindung liegt Aufgabe zugrunde, eine Schaltungsanordnung zum überwachen der Betriebsspannung anzugeben, die eine besonders schnelle Reaktionszeit aufweist, um den Kondensator möglichst schnell zu entladen.

Erfindungsgemäß wird die Aufgabe bei der Schaltungsanordnung der eingangs genannten Art durch die im kennzeichnenden Teil des Patentanspruchs 1 angegebenen Merkmale gelöst.

Es wäre denkbar, den zweiten und den dritten Komparator ausgangsseitig parallel zu schalten, um durch beide Komparatoren ein Entladen des Kondensators zu bewirken. Zweckmäßigerweise wird jedoch der Ausgang des dritten Komparators mit demjenigen Eingang des zweiten Komparators verbunden, an dem die Betriebsspannung anliegt.

Es ist möglich, für den ersten Komparator und den zweiten Komparator unterschiedliche Bezugsspannungen zu verwenden, jedoch erweist es sich als zweckmäßig, die Schaltungsanordnung derart zu dimensionieren, daß beide Bezugsspannungen identisch sind.

Um ein sicheres Arbeiten des dritten Komparators zu gewährleisten, ist es vorteilhaft, wenn im Verbindungsweg zwischen der Betriebsspannung und dem Kondensator eine Diode vorgesehen ist. Um unabhängig von der Betriebsspannung ein zuverlässiges Arbeiten der Schaltungsanordnung sicherzustellen, ist es vorteilhaft, wenn eine Hilfsspannungsquelle vorgesehen ist, aus der die Versorgungsspannungen für die Komparatoren und die Bezugsspannungen erzeugbar sind. Weiterhin erweist es sich als zweckmäßig, mindestens einen Teil der Komparatoren mit Mitkopplungswiderständen zu versehen, so daß die Komparatoren ein Schmitt-Trigger-Verhalten auf -weisen.

Im folgenden wird ein Ausführungsbeispiel der Schaltungsanordnung gemäß der Erfindung anhand von Zeichnungen näher erläutert. Es zeigen

Fig. 1 ein Blockschaltbild der Schaltungsanordnung,

Fig. 2 ein Zeitdiagramm von Signalen an verschiedenen Punkten der Schaltungsanordnung,

Fig. 3 ein Schaltbild der Schaltungsanordnung.

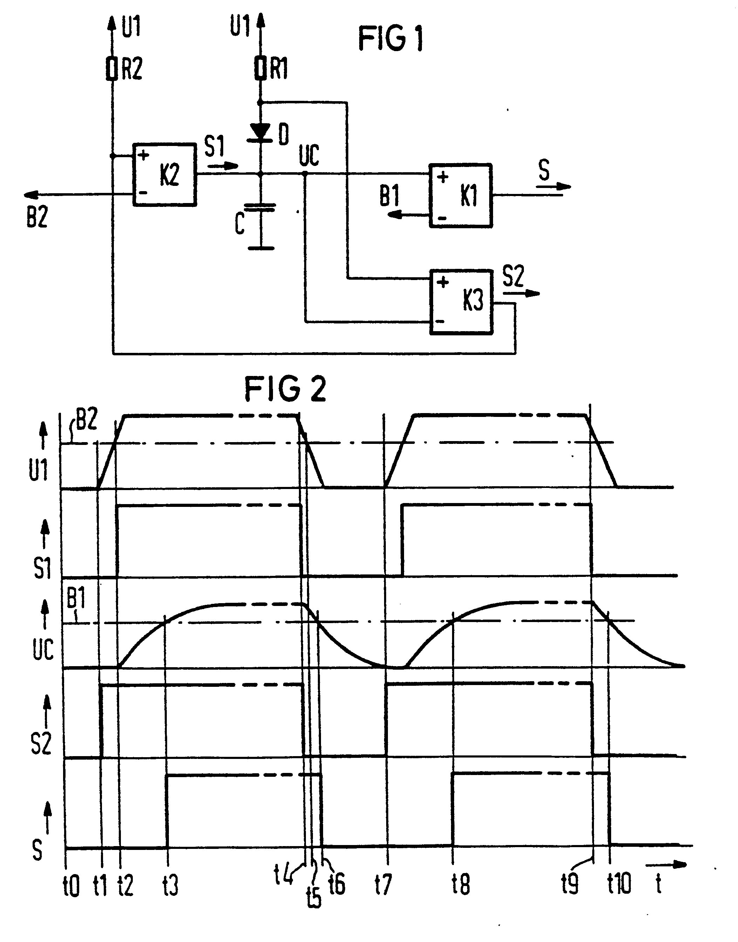

Bei dem in Fig. 1 dargestellten Schaltbild liegt die zu überwachende Betriebsspannung U1 über einen Ladewiderstand R1 und eine Diode D an einem Kondensator C an. Die Spannung UC am Kondensator C wird einem ersten Eingang eines Komparators K1 zugeführt, der diese Spannung UC mit einer an seinem zweiten Eingang anliegenden Bezugsspannung B1 vergleicht und immer dann an seinem Ausgang ein Steuersignal S abgibt, wenn die Spannung UC größer ist als die Bezugsspannung B1. Die Betriebsspannung U1 liegt weiterhin über einen Widerstand R2 an einem ersten Eingang eines zweiten Komparators K2 an, an dessen zweitem Eingang eine Bezugsspannung B2 anliegt, die mit der Bezugsspannung B1 identisch sein kann. Der Komparator K2 bewirkt durch ein an seinem Ausgang liegendes Signal S1, daß der Kondensator C entladen wird, wenn die über den Widerstand R2 anliegende Betriebsspannung U1 kleiner ist als die Bezugsspannung B2.

Die Betriebsspannung U1 liegt über den Ladewiderstand R1 auch an einem ersten Eingang eines dritten Komparators K3 an, an dessen zweitem Eingang die Spannung UC am Kondensator C anliegt. Dieser Komparator K3 bewirkt ebenfalls ein Entladen des Kondensators C durch ein Signal S2, wenn die über den Ladewiderstand R1 anliegende Betriebsspannung U1 kleiner ist als die Spannung UC. Der Ausgang des Komparators K3 kann zu diesem Zweck unmittelbar am Kondensator C angeschlossen sein. Es ist auch möglich, wie in Fig. 1 dargestellt, den Ausgang des Komparators K3 mit dem ersten Eingang des Komparators K2 zu verbinden.

Weitere Einzelheiten der Schaltungsanordnung werden im folgenden zusammen mit den in Fig. 2 dargestellten Zeitdiagrammen beschrieben.

Bei den in Fig. 2 dargestellten Zeitdiagrammen ist in Abszissenrichtung die Zeit t dargestellt. In Ordinatenrichtung sind die Momentanwerte von Signalen an verschiedenen Punkten der Schaltungsanordnung dargestellt.

Zum Zeitpunkt t0 wird davon ausgegangen, daß die Betriebsspannung U1 abgeschaltet ist. Die Spannung UC ist damit kleiner als die Bezugsspannung B1 und das Steuersignal S hat seinen aktiven Binärwert 0 und kann beispielsweise als Rücksetzsignal für ein digitales Schaltwerk verwendet werden. Zum Zeitpunkt t1 wird die Spannungsquelle für die Betriebsspannung U1 eingeschaltet und die Betriebsspannung U1 wächst rampenförmig an. Sobald die über den Ladewiderstand R1 am Komparator K3 anliegende Betriebsspannung U1 größer wird als die Spannung UC, nimmt das Signal S2 den Binärwert 1 an.

Wenn zum Zeitpunkt t2 die Betriebsspannung U1 größer wird als die Bezugsspannung B2, nimmt auch das Signal S1 den Binärwert S1 an und beendet das Entladen des Kondensators C.

Der Kondensator C wird damit entsprechend einer Exponentialfunktion aufgeladen. Wenn die Spannung UC zum Zeitpunkt t3 die Bezugsspannung B1 überschreitet, nimmt das Steuersignal S den Binärwert 1 an und zeigt damit an, daß die Betriebsspannung U1 vollständig zur Verfügung steht. Gleichzeitig kann damit beispielsweise das Rücksetzen des digitalen Schaltwerks beendet werden.

Es wird angenommen, daß zum Zeitpunkt t4 eine Störung der Betriebsspannung U1 in Form eines kurzzeitigen Einbruchs auftritt. Sobald die am ersten Eingang des Komparators K3 anliegende, der Betriebsspannung U1 zugeordnete Spannung kleiner wird als die Spannung UC, nimmt das Signal S2 den Binärwert 0 an und bewirkt über den ersten Eingang des Komparators K2, daß auch das Signal S1 den Binärwert 0 annimmt und sofort eine Entladung des Kondensators C veranlaßt. Ohne die Verwendung des Komparators K3 würde erst zum Zeitpunkt t5 eine Entladung des Kondensators C stattfinden, nämlich dann, wenn die Betriebsspannung U1 am ersten Eingang des Komparators K2 die Bezugsspannung B2 unterscheidet. Zum Zeitpunkt t6 unterschreitet die Spannung UC die Bezugsspannung B1 und das Signal S nimmt den Binärwert 0 an und zeigt damit an, daß die Betriebsspannung U1 gestört ist.

Wenn zum Zeitpunkt t7 die Störung der Betriebsspannung U1 beendet ist, nimmt das Signal S2 wieder den Binärwert 1 an und beendet ein Entladen des Kondensators C. Anschließend wiederholen sich zwischen den Zeitpunkten t7 und t8 die gleichen Vorgänge wie zwischen den Zeitpunkten t1 und t3. Zum Zeitpunkt t8 wird dann das Steuersignal S wieder beendet und damit angezeigt, daß die Betriebsspannung U1 wieder vollständig zur Verfügung steht.

Beim Abschalten der Betriebsspannung U1 wiederholen sich zwischen den Zeitpunkten t9 und t10 die gleichen Vorgänge wie zwischen den Zeitpunkten t4 und t6. Das Steuersignal S nimmt dann zum Zeitpunkt t10 wieder den Binärwert 0 an, um anzuzeigen, daß die Betriebsspannung nicht mehr vollständig zur Verfügung steht.

Falls das Steuersignal S als Rücksetzsignal für ein digitales Schaltwerk benutzt wird, können also bis unmittelbar nach dem Einschalten, während kurzzeitiger Störungen und nach dem Abschalten der Betriebsspannung durch das Steuersignal S jeweils definierte Zustände eingestellt werden.

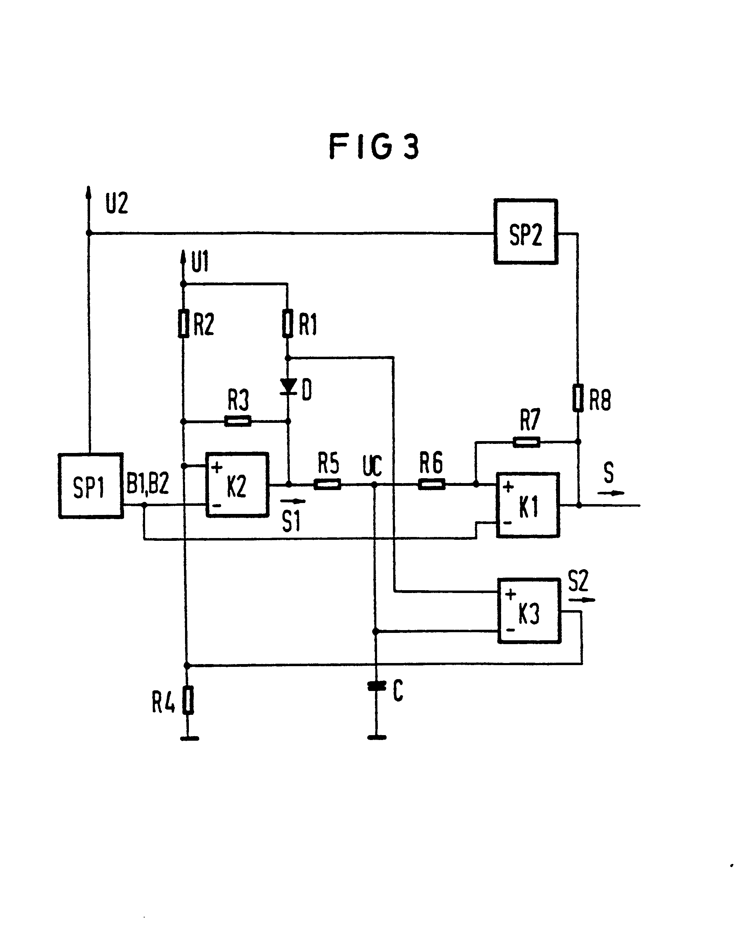

Bei dem in Fig. 3 dargestellten Schaltbild ist eine Hilfsspannungsquelle U2 vorgesehen, die einerseits die Versorgungsspannungen für die Komparatoren K1 bis K3 erzeugt und die andererseits über Spannungsquellen SP1 und SP2 die Bezugsspannungen B1 und B2 bzw. die Ausgangsspannung des Komparators K1 festlegen. Die Bezugsspannungen B1 und B2 sind im vorliegenden Ausführungsbeispiel identisch. Als Komparatoren K1 bis K3 können beispielsweise im Handel unter der Bezeichnung LM339 erhältliche Komparatoren verwendet werden. Diese Komparatoren enthalten keine Kollektorwiderstände, so daß diese durch die Widerstände R8, R1 und R2 realisiert werden. Die Komparatoren K1 und K2 sind mit Mitkopplungswiderständen R7 bzw. R3 versehen, um ein Schmitt-Trigger-Verhalten zu erreichen. Die Zeitkonstante, mit der der Kondensator C aufgeladen wird, bestimmt sich aus den Widerständen R1 und R5 und der Kapazität des Kondensators C. Die Entladezeitkonstante hängt vom Widerstand R5 und der Kapazität des Kondensators C ab. Die Widerstände R6 und R7 bestimmen die Verstärkung des Komparators K1. Die Arbeitsweise der Schaltungsanordnung entspricht derjenigen der in Fig. 1 dargestellten Schaltungsanordnung.

## Patentansprüche

1. Schaltungsanordnung zum Überwachen einer Betriebsspan -nung (U1), bei der ein kondensator (C) in Abhängigkeit von der Betriebsspannung (U1) aufgeladen und entladen wird, bei der ein erster Komparator (K1) vorgesehen ist, der die Spannung (UC) am Kondensator mit einer ersten Bezugsspannung (B1) vergleicht und der ein Steuersignal (S) abgibt, wenn die Spannung am Kondensstor kleiner ist als die erste Bezugsspannung (B1) und bei der ein zweiter Komparator (K2) vorgesehen ist, der die Betriebsspannung (U1) mit einer zweiten Bezugsspannung (B2) vergleicht, dadurch gekennzeichnet, daß der zweite Komparator (K2) den Kondensator (C) entlädt, wenn die Betriebsspannung (U1) kleiner ist als die zweite Bezugsspannung (B2) und daß ein dritter Komparator (K3) vorgesehen ist, der die Spannung (UC) am Kondensator (C) mit der Betriebsspannung (U1) vergleicht und der den Kondensator (C) entlädt, wenn die Betriebsspannung (U1) kleiner ist als die Spannung (UC) am Kondensator (C).

2. Schaltungsanordnung nach Anspruch 1, dadurch gekennzeichnet , daß der Ausgang des dritten Komparators (K3) mit demjenigen Eingang des zweiten Komparators (K2) verbunden ist, an dem die Betriebsspannung (U1) anliegt.

3. Schaltungsanordnung nach Anspruch 1 oder Anspruch 2, dadurch gekennzeichnet , daß die an dem ersten Komparator (K1) und dem zweiten Komparator (K2) anliegenden Bezugsspannungen (B1 bzw. B2) identisch sind.

4. Schaltungsanordnung nach einem der Ansprüche 1 bis 3, dadurch gekennzeichnet , daß im Verbindungsweg zwischen einem an der Betriebsspannung (U1) angeschlossenen Ladewiderstand (R1) und dem Kondensator (C) eine Diode (D) angeordnet ist.

5. Schaltungsanordnung nach einem der Ansprüche 1 bis 4, dadurch gekennzeichnet , daß die Betriebsspannung (U1) dem zweiten Komparator (K2) und dem dritten Komparator (K3) über einen Widerstand (R2) bzw. über den Ladewiderstand (R1) zugeführt wird.

6. Schaltungsanordnung nach einem der Ansprüche 1 bis 5, dadurch gekennzeichnet , daß eine Hilfsspannung (U2) Vorgesehen ist, aus der die Bezugsspannungen (B1, B2) und die Versorgungsspannungen für die Komparatoren (K1 bis K3) erzeugbar sind.

7. Schaltungsanordnung nach einem der Ansprüche 1 bis 6, dadurch gekennzeichnet , daß zumindest ein Teil der Komparatoren (K1, K2) mit Mitkopplungswiderständen (R7, R3) versehen ist.

## Claims

1. A circuit arrangement for monitoring an operating voltage (U1), wherein a capacitor (C) is charged and discharged in dependence upon the operating voltage (U1), wherein a first comparator (K1) compares the voltage (VC) applied to the capacitor with a first reference voltage (B1) and emits a control signal (S) if the voltage applied to the capacitor is lower than a first reference voltage (B1), and wherein a second comparator (K2) compares the operating voltage (U1) with a second reference voltage (B2), characterised in that the second comparator (K2) discharges the capacitor (C) when the operating voltage (U1) is lower than the second reference voltage (B2) and that a third comparator (K3) is provided which compares the voltage (UC) applied to the capacitor (C) with the operating voltage (U1) and discharges the capacitor (C) if the operating voltage (U1) is lower than the voltage (UC) applied to the capacitor (C).

2. A circuit arrangement as claimed in claim 1, characterised in that the output of the third comparator (K3) is connected to that input of the second comparator (K2) to which the operating voltage (U1) is connected.

3. A circuit arrangement as claimed in Claim 1 or 2, characterised in that the reference voltages (B1 and B2) connected to the first comparator (K1) and the second comparator (K2) are identical.

4. A circuit arrangement as claimed in one of Claims 1 to 3, characterised in that a diode (D) is arranged in the connection path between a load resistor (R1), connected to the operating voltage (U1), and the capacitor (C).

5. A circuit arrangement as claimed in one of Claims 1 to 4, characterised in that the operating voltage (U1) is respectively fed to the second comparator (K2) via a resistor (R2) and to the third comparator (K3) via the load resistor (R1).

6. A circuit arrangement as claimed in one of Claims 1 to 5, characterised in that the reference voltages (B1, B2) and the supply voltages for the comparators (K1 to K3) are generated from an auxiliary voltage (U2).

7. A circuit arrangement as claimed in one of Claims 1 to 6, characterised in that least a part of the comparators (K1, K2) is provided with positive feedback resistors (R7, R3).

## Revendications

1. Montage pour surveiller une tension de fonctionnement (U1), dans lequel un condensateur (C) est chargé et déchargé en fonction de la tension de fonctionnement (U1), dans lequel est prévu un premier comparateur (K1) qui compare la tension (UC) sur le condensateur avec une premièe tension de référence (B1) et qui délivre un signal de commande (S) quand la tension au condensateur est inférieure à la première tension de référence (B1) et dans lequel est prévu un second comparateur (K2) qui compare la tension de fonctionnement (U1) avec une deuxième tension de référence (B2), caractérisé en ce que le second comparateur (K2) décharge le condensateur (C) lorsque la tension de fonctionnement (U1) est inférieure à la deuxième tension de reference (B2) et qu'un troisième comparateur (K3) est prévu, qui comparmela tension (UC) au condensateur (C) avec la tension de fonctionnement (U1) et qui décharge le condensateur (C) lorsque la tension de fonctionnement (U1) est inférieure à la tension au condensateur (C).

2. Montage selon la revendication 1, caractérisé en ce que la sortie du troisième comparateur (K3) est connectée à l'entrée recevant la tension de fonctionnement (U1) du second comparateur (K2).

3. Montage selon la revendication 1 ou 2, caractérisé en ce que les tensions de référence (B1 respectivement B2) appliquées au premier comparateur (K1) et au second comparateur (K2) sont identiques.

4. Montage selon une des revendications 1 à 3, caractérisé en ce qu'une diode (D) est disposée dans la liaison entre une résistance de charge (R1) raccordée à la tension de fonctionnement (U1) et le condensateur (C).

5. Montage selon une des revendications 1 à 4, caractérisé en ce que la tension de fonctionnement (U1) est appliquée au second comparateur (K2) et au troisième comparateur (K3) à travers une résistance (R2) respectivement à travers la résistance de charge (R1).

6. Montage selon une des revendications 1 à 5, caractérisé en ce qu'une tension auxiliaire (U2) est prévue, à partir de laquelle peuvent être produites les tensions de référence (B1, B2) et les tensions d'alimentation pour les comparateurs (K1 à K3).

7. Montage selon une des revendications 1 à 6, caractérisé en ce qu'une partie au moins des comparateurs (K1, K2) est dotée de résistances de rétroaction (R7, R3).

# FIG 1

# FIG 2

# FIG 3